# EUROPEAN PATENT SPECIFICATION

(11) **EP 2 120 004 B1**
(45) Date of publication and mention of the grant of the patent: **29.12.2010**
(21) Application number: 09160005.6
(22) Date of filing: 12.05.2009
(51) Int. Cl.: G01B 7/016, H03K 5/08

(54) **Sensor signal detection circuit**
Sensorsignaldetektionsschaltung
Circuit de détection de signal de capteur

(30) Priority: 15.05.2008 JP 2008128623
(43) Date of publication of application: 18.11.2009
(73) Proprietor: Mitutoyo Corporation, Kawasaki-shi Kanagawa 213-8533 (JP)
(72) Inventor: Yoshitani, Satoshi, Kanagawa 213-8533 (JP)
(74) Representative: Grünecker, Kinkeldey, Stockmair & Schwanhäusser Anwaltssozietät

(56) References cited:
- EP-A- 1 257 058
- GB-A- 2 318 232
- US-A- 5 142 554

## Description

### BACKGROUND OF THE INVENTION

### Field of the Invention

The present invention relates to a sensor signal detection circuit, more specifically to a sensor signal detection circuit that detects an abruptly-changing DC level variation component from a DC sensor signal.

### Description of the Related Art

Heretofore known as measuring instruments that execute measurement of a form and dimensions of an object to be measured are a height gauge, a three-dimensional measuring machine, a contour measuring machine, and so on. In contact types of such measuring instruments a touch signal probe that detects a contact with the object to be measured is used. There are various kinds of touch signal probe contact sensor mechanisms; one kind is an ultrasonic touch trigger probe. This employs a system in which vibrations are applied to a stylus using a piezoelectric element and changes in amplitude and frequency of the vibrations are monitored (for example, refer to Japanese Unexamined Patent Application Publication No. 06-221806).

In this contact sensor system employing piezoelectric element, a piezoelectric element is excited in a resonant state by positive feedback control and a detection output signal obtained from a detector electrode of the piezoelectric element forms a sinusoidal waveform signal. An amplitude and a frequency of this sinusoidal waveform signal change as a contact makes contact with an object to be measured. Therefore, to detect a contact through amplitude data, for example, an amplitude change detection circuit is used that obtains a DC sensor signal that contains only the amplitude data detected and extracted from the obtained sinusoidal waveform signal and generates a touch trigger signal at a point of abrupt variation of DC level of this DC sensor signal due to the contact. Specifically, the touch trigger signal is generated on comparison of a DC sensor signal S with a fixed reference potential VREF.

However, when the fixed reference potential VREF is used, misdetection becomes a problem. That is to say, in many cases, the DC sensor signal S has a low frequency state variation component showing a slow amplitude change due to a surge or the like, and a high frequency noise component, both superimposed on a DC offset component. Consequently, depending on a setting of the reference potential VREF, the low frequency state variation component and high frequency noise overlap, apart from the touch trigger signal generated at the point of abrupt change of DC level of the sensor signal S, and this overlapping ends up being a major cause of detection errors.

For solution of this problem, a technology is known that extracts the above-mentioned DC sensor signal and low frequency state variation component using a low-pass filter, amplifies the DC sensor signal including this low frequency state variation component. Then, the amplitude-converted signal is used as a reference signal. This technology is proposed in Japanese Unexamined Patent Application Publication No. 10-111143.

However, with the technology of this Japanese Unexamined Patent Application Publication No. 10-111143, there has been a risk of false detection. Specifically, although the touch signal probe is kept in a state of continuous contact with the object to be measured, the probe mistakenly detects disengagement from the object to be measured.

Document GB 2 318 232 A relates to a detecting circuit for detecting abrupt DC level transmission in a DC sensor signal on which a waviness component and a noise component are superimposed, comprising a low-pass filter, amplitude transforming means and comparing means for comparing the DC sensor signal with the reference signal output from the amplitude transforming means to extract a DC level transition component. Document GB 2 318 232 A does not define a second reference signal generating portion and a selecting portion. These two features enable a reduction of false touch detections, since it only comprises one reference signal generating portion.

### SUMMARY OF THE INVENTION

According to one aspect the present invention provides a sensor signal detection circuit for detecting a change in a DC sensor signal (S) including a low frequency state variation component and a high frequency noise component both superimposed on a DC level variation component, the DC level variation component caused by a change in a physical quantity to be detected, comprising: a comparing portion (24) for sampling a reference signal (R) and said DC sensor signal to obtain a first sampling signal and a second sampling signal, respectively, and compares the first sampling signal and second sampling signal to output a comparison signal; a low-pass filter (21) inputted with said DC sensor signal and cuts off said high frequency noise component and said DC level variation component from said DC sensor signal to allow passage of said low frequency state variation component; a first reference signal generating portion (22) for converting amplitude of an output signal of the low-pass filter at a fixed ratio to generate a first reference signal; a second reference signal generating portion (25) for generating, in the case that said comparison signal is outputted, a second reference signal having a fixed value based on said first or second sampling signals at a time of output of the comparison signal; and a selecting portion (23) for selecting as said reference signal said first reference signal or said second reference signal and inputs it to said comparing portion.

### BRIEF DESCRIPTION OF THE DRAWINGS

Fig. 1 shows an example of a configuration of a contact sensor according to an embodiment of the present invention.
Fig. 2 is a block diagram showing an example of a configuration of a contact detecting circuit 10 shown in Fig. 1.
Fig. 3 is a graph showing an operation of the present embodiment.
Fig. 4 is a graph describing an operation of a comparative example in order to illustrate an advantage of the present invention.
Fig. 5 is a graph describing an operation of a comparative example in order to illustrate an advantage of the present invention.
Fig. 6 is a graph describing a variant example of the present invention.

### DETAILED DESCRIPTION OF THE EMBODIMENTS

An embodiment of the present invention is now described in detail with reference to the drawings.

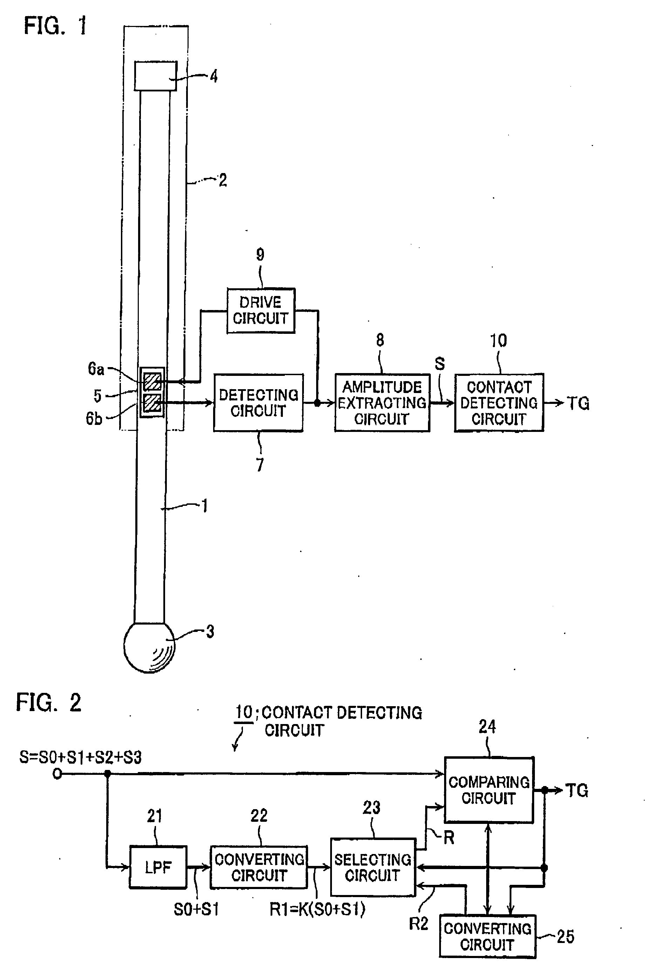

Fig. 1 shows an example of a configuration of a contact sensor to which the present invention is applied. A stylus 1 has at a leading end thereof a spherical contact 3. In addition, provided at a back end of the stylus 1 is a balancer 4 that maintains positioning of the stylus 1. Moreover, the stylus 1 is held at its roughly central portion of an axial direction thereof by a stylus holder 2.

Fixed to a roughly central portion of the stylus 1 is a piezoelectric element 5 that applies a vibration to the stylus 1. The piezoelectric element 5 is provided with an exciter electrode 6a for applying the vibration to the stylus 1 and a detector electrode 6b for detecting a contact of the contact 3. Applied to this exciter electrode 6a is a drive signal from a drive circuit 9.

A mechanical-electrical conversion output signal obtained in the detector electrode 6b is detected by a detecting circuit 7. An output signal of the detecting circuit 7 is positively fed back to the drive circuit 9 and, through this feedback control, the piezoelectric element 5 is excited at a certain resonant frequency.

A detection output signal outputted from the detecting circuit 7 is a sinusoidal waveform signal that decreases in amplitude through the contact of the contact 3 with an object to be measured. An amplitude extracting circuit 8 detects this detection output signal of the detecting circuit 7 to output a DC sensor signal S. Specifically, the amplitude extracting circuit 8 is configured by a full-wave rectifying circuit and a low-pass filter, for example.

A contact detecting circuit 10 detects a change in a DC level variation component S3 that abruptly decreases through the contact of the contact 3 and generates a trigger signal TG (comparison signal).

Details of a configuration of this contact detecting circuit 10 are now explained with reference to Fig. 2. The contact detecting circuit 10 includes a low-pass filter 21 to which the DC sensor signal S is inputted, and a converting circuit 22 (first reference signal generating portion) that converts a level of an output signal of this low-pass filter 21 by multiplying the output signal of this low-pass filter 21 by a fixed coefficient K, as shown in Fig. 2.

The DC sensor signal S inputted to the low-pass filter 21 includes a DC offset component S0, a low frequency state variation component S1 (variation due to temperature change or temporal change), a high frequency noise component S2, and the DC level variation component S3 that is a signal component detected through the contact of the contact 3 (S = S0 + S1 + S2 + S3).

Of the various components of this DC sensor signal S, the low-pass filter 21 cuts off the high frequency noise component S2 and the DC level variation component S3 to allow passage of only the DC offset component S0 and the low frequency state variation component S1 (S0 + S1). The converting circuit 22 outputs a signal R1 = K (S0 + S1) (first reference signal) obtained by multiplying the output signal (S0 + S1) by the coefficient K (a positive value less than 1). This signal R1 is selectively used as a reference signal R, as described hereafter.

Note that this coefficient K is determined giving consideration to a size of an amplitude of the high frequency noise component S2. That is to say, by setting a size of ΔS = (1 - K) (S0 + S1) to be greater than a maximum amplitude |S2| of the high frequency noise component S2, a high-precision contact detection becomes possible without being affected by the high frequency noise component S2. However, if the coefficient K is set to be too small, a time of occurrence of the touch-trigger signal TG becomes different from an actual time of contact of the contact 3. It is therefore preferable that the coefficient K be set to as large a value as possible in a range that is unaffected by the high frequency noise component S2.

In addition, the contact detecting circuit 10 includes a selecting circuit 23, a comparing circuit 24, and a converting circuit 25.

The selecting circuit 23 (selecting portion) selects, as the reference signal R, either the signal R1 (= K (S0 + S1)) obtained from the converting circuit 22, or a signal R2 obtained from the converting circuit 25 to be described hereafter, in accordance with the trigger signal TG. Specifically, while the trigger signal TG is in a risen state, the signal R2 is chosen as the reference signal R, and while the trigger signal TG is in a fallen state, the signal R1 is chosen as the reference signal R. The signal R2 is a fixed value as described hereafter.

The comparing circuit 24 (comparing portion) has a function of sampling the DC sensor signal S and the reference signal R at a certain timing to obtain a first sampling signal Ssamp and a second sampling signal Rsamp. Then, these sampling signals are compared. In the case of Ssamp < Rsamp, the trigger signal is raised. conversely, in the case of Ssamp ≧ Rsamp, the trigger signal is fallen.

The converting circuit 25 (second reference signal generating portion), in a case that a rise of the trigger signal TG is detected at a certain time t1, downloads from the comparing circuit 24 a sampling value Rt1 of the sampling signal Ssamp or Rsamp at that time t1, multiplies this sampling value Rt1 by a coefficient m to give the signal R2=m·Rt1 (second reference signal) and outputs this signal R2. Here, the coefficient m is a constant greater than 1, and is determined giving consideration to a size of an amplitude of the high frequency noise component S2. That is to say, the signal R2 is a fixed value.

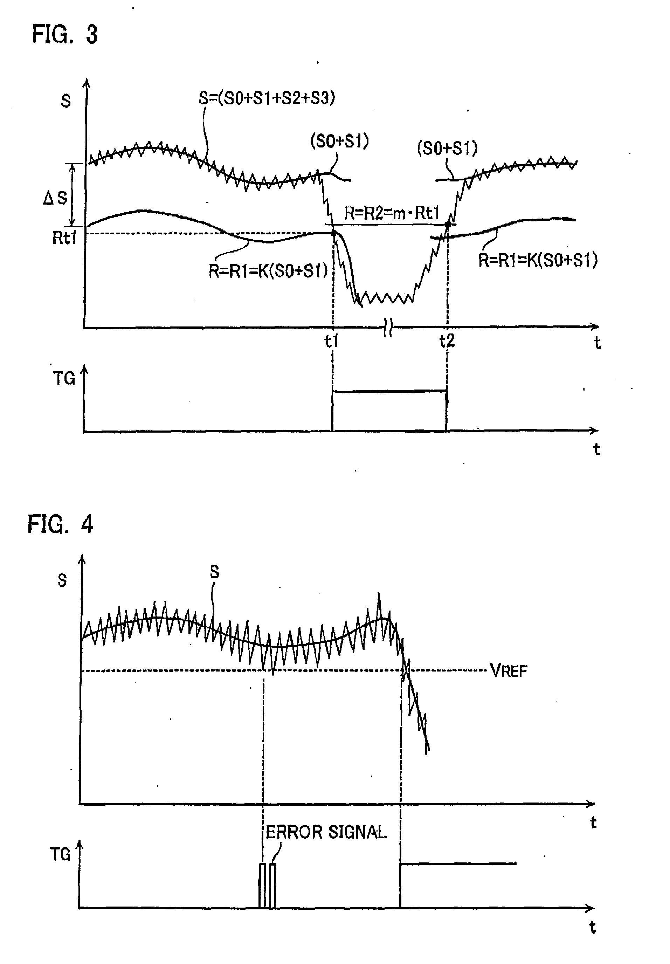

An operation of the contact detecting circuit 10 in this embodiment is described with reference to Fig. 3. Here, an example is taken of a case in which, in an initial state (non-contact state), the contact 3 of the stylus 1 is disengaged from the object to be measured (not shown); the contact 3 then makes contact with the object to be measured, and that contact state is maintained for a period of time; the contact 3 then disengages again from the object to be measured (shifts to the non-contact state).

In this case, when the DC sensor signal S is inputted to the low-pass filter 21, the high frequency noise component S2 and the transient DC level variation component S3 are cut off, and the signal (S0 + S1) of only the DC offset component S0 and the low frequency state variation component S1 is outputted from the low-pass filter 21. The converting circuit 22 multiplies this output signal (S0 + S1) by the coefficient K, and outputs the signal R1 = K (S0 + S1).

The selecting circuit 23 selects this signal R1 as the reference signal R while the trigger signal TG is in a fallen state. This reference signal R ( = K (S0 + S1)) is compared with the DC sensor signal S (both are sampling values as described above) in the comparing circuit 24. In a case in which it is detected that S has become less than R (S < R) at time t1, the comparing circuit 24 raises the trigger signal TG.

The converting circuit 25, in a case that a rise of this trigger signal TG is detected, requests the comparing circuit 24 to transmit the sampling value Rt1 at that time t1. The comparing circuit 24 receives this request, reads out that sampling value Rt1 from its own latch circuit (not shown) and outputs that sampling value Rt1 towards the converting circuit 25. The converting circuit 25 multiplies this sampling value Rt1 by the coefficient m to generate the signal R2 = m·Rt1.

The selecting circuit 23 selects the signal R2 in place of the signal R1 as the reference signal R at the time t1 that the trigger signal TG is raised. That is to say, the reference signal R is switched from a variable value derived from the DC sensor signal S to a fixed value, with time t1 as a boundary. Note that a timing at which the reference signal R is switched from the signal R1 to the signal R2 need not be at time t1, but may also be after a certain time lag after time t1.

Thereafter, a state in which the contact 3 is in contact with the object to be measured is continued for a certain period, and then, when at a time t2 the contact 3 disengages from the object to be measured, the fact that R has become less than S (R < S) is detected by the comparing circuit 24, and the trigger signal TG falls. The selecting circuit 23 once again selects the signal R1 in place of the signal R2 as the reference signal R at the time t2 at which the trigger signal TG fell. That is to say, the reference signal R is switched from the fixed value to the value derived from the DC sensor signal S, with time t2 as a boundary. Note that a timing at which the reference signal R is switched from the signal R2 to the signal R1 need not be at time t2, but may also be after a certain time lag after time t2. In this way, the present embodiment uses the above-described signal R2, namely the fixed value, as the reference signal R during the rise period of the trigger signal TG (when the contact 3 is in a state of contact), and uses the variation component R1 derived from the DC sensor signal S as the reference signal R during the fall period of the trigger signal TG (when the contact 3 is in a state of non-contact). Switching the reference signal R in this way makes it possible to more accurately judge contact/non-contact of the contact 3, in comparison with a case in which the reference signal R is fixed at the fixed value and a case in which the variation component R1 continues to be used as the reference signal R. In the above-mentioned example shown in Fig. 3, a case is described in which contact between the contact 3 and the object to be measured shifts from a state of non-contact to a state of contact, the state of contact then continues for a certain period, before subsequently being returned again to the state of non-contact, but it goes without saying that the present invention is not limited to this case. For example, the present invention is applicable also to such a case as that in which the contact 3 does not return from the contact state to the non-contact state but the contact state is maintained for a long period.

For comparison, problems are described of a case in which the reference signal R is permanently fixed at a fixed value VREF.

The DC sensor signal S includes the low frequency state variation component S1 and the high frequency noise component S2, as described above. As a result, in a case in which the reference signal R is set to the fixed value VREF and this value VREF is too large, in a worst-case scenario of superimposition of the low frequency state variation component S1 and the high frequency noise component S2, it may occur that the signal S falls below the reference signal R, as shown in Fig. 4 (refer to Fig. 4). In this case, the contact 3 is mistakenly detected as having made contact with the object to be measured even though it is not in contact.

In contrast, in a case in which the variation component R1 = K (S0 + S1) derived from the DC sensor signal S is used fixedly as the reference signal R, there is at least no influence from the low frequency state variation component S1 and therefore no occurrence of a mistaken detection such as that of Fig. 4.

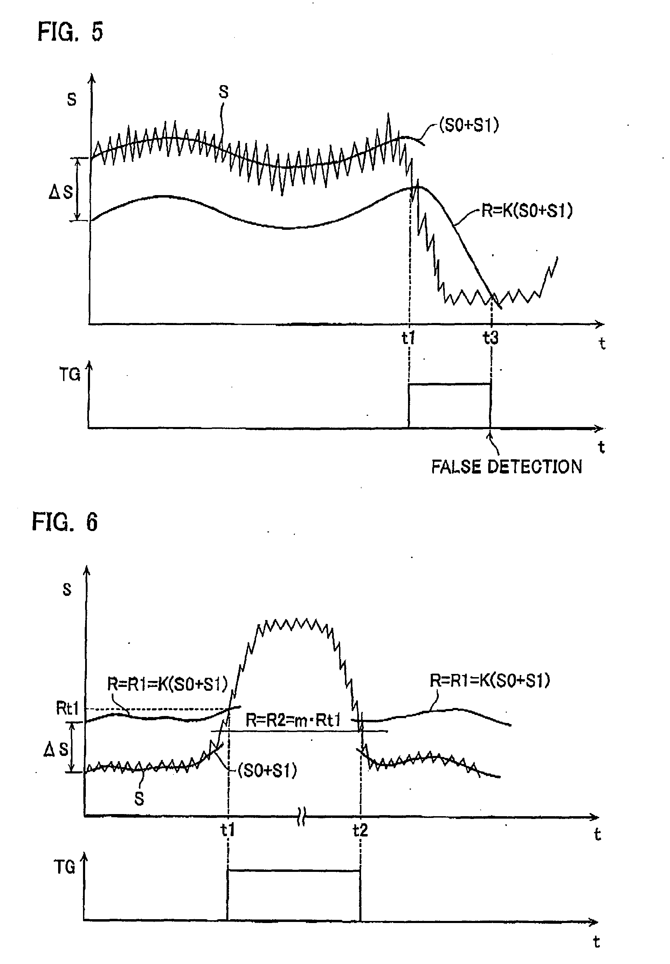

However, in this case, as shown in Fig. 5, in a case in which a state of contact between the contact 3 and the object to be measured is continued for a certain period after the time t1 at which the contact is detected, it may occur that at a time t3 the variation component R1 becomes smaller than the DC sensor signal S. In this case, there occurs a fall in the trigger signal TG and a mistaken detection even though the contact 3 continues to be in contact with the object to be measured.

Regarding this point, the present embodiment has no problem such as that of Fig. 4, because with the contact 3 in a state of non-contact the reference signal R is generated on the basis of the variation component R1. Neither is there any occurrence in the present embodiment of a problem such as that of Fig. 5, because, by contrast, in the case that the contact 3 is in a contact state a fixed value of the reference signal R is used. Consequently, in accordance with the present embodiment, an accurate detection can be enjoyed without any mistaken detection, even in a case that contact between the contact 3 and the object to be measured is continued for a certain period.

This concludes description of the embodiment of the present invention, but it should be noted that the present invention is not limited to the above-described embodiment, and that various alterations, additions, and so on, are possible within a range not departing from the scope and spirit of the invention. For example, in the above-described embodiment, the various circuits 21-25 may be realized with software using a digital signal processor (DSP).

Moreover, in the above-described embodiment, an example is shown of a contact sensor using an ultrasonic touch trigger probe in which contact detection is executed by extracting the amplitude of the DC sensor signal, but the present invention is not limited to this example. For example, it is possible to apply the present invention also to a case in which a frequency and a phase of the DC sensor signal are detected and the contact is detected on the basis of a change in this frequency and phase. The point is that the present invention can be applied to any sensor that includes a low frequency state variation component in the sensor signal.

Furthermore, in the aforementioned example a contact sensor is described, but the present invention is not limited to this, and can be applied, for example, also to a pressure sensor, an accelerometer, and so on.

In addition, in the above-described embodiment, a case is described in which the amplitude of the signal component S3 decreases in a case that contact is detected, but, conversely, the present invention can be applied also to a case in which the amplitude and so on of the signal component S3 increase in the case that contact is detected (refer to Fig. 6). However, in this case, contrary to the above-described embodiment, K is set to a number greater than 1, while m is set to a number less than 1. Moreover, in the above-described embodiment, the sampling value Rt1 is multiplied by the coefficient m to generate the signal R2=m·Rt1 in the converting circuit 25, but the present invention is not limited to this. The signal R2 may be generated by addition (R2 - Rt1 + n), or by multiplication and addition (R2=m·Rt1 + n). The point is that, in a case of Fig. 3, the signal R2 need only become a value greater than the sampling value Rt1, and, conversely, in a case of Fig. 6, the signal R2 need only be set to a value smaller than the sampling value Rt1. There is no limitation to a specific formula.

## Claims

1. A sensor signal detection circuit (10) for detecting a change in a DC sensor signal (S) including a low frequency state variation component (S₁) and a high frequency noise component (S₂) both superimposed on a DC level variation component (S₃), the DC level variation component being caused by a change in a physical quantity to be detected, comprising:
a comparing portion (24), for sampling a reference signal (R) and said DC sensor signal (5) to obtain a first sampling signal and a second sampling signal, respectively, and for comparing the first sampling signal and second sampling signal to output a comparison signal;
a low-pass filter (21) inputted with said DC sensor signal (S) and arranged to cut off said high frequency noise component (S₂) and said DC level variation component (S₃) from said DC sensor signal (S) to allow passage of said low frequency state variation component (S₁),
a first reference signal generating portion (22) for converting amplitude of an output signal of the low-pass filter (21) at a fixed ratio (K) to generate a first reference signal (R₁),
a second reference signal generating portion (25) for generating, in the case that said comparison signal is outputted, a second reference signal having a fixed value based on said first or second sampling signals at a time of output of the comparison signal (R₁); and
a selecting portion (23) for selecting as said reference signal (R) said first reference signal or said second reference signal and for inputting it to said comparing portion.

2. The sensor signal detection circuit according to claim 1, arranged so that in the case that said second reference signal is newly generated while said first reference signal is selected as said reference signal, said selecting portion newly selects said second reference signal in place of said first reference signal; and in the case that said comparison signal is newly outputted as a result of a comparison between the said second reference signal and said DC sensor signal in said comparing portion, said selecting portion newly selects said first reference signal as said reference signal.

3. The sensor signal detection circuit according to claim 1, arranged so that said second reference signal is a fixed value obtained by multiplying said first sampling signal at a time of output of said comparison signal by a certain coefficient, and/or adding a certain coefficient to said first sampling signal at a time of output of said comparison signal.

4. A touch sensor comprising:
a stylus (1) having a contact for contacting an object to be measured;
an exciting portion (6b) for applying vibration to the stylus; and
a sensor signal detection circuit (10) according to claim 1.

## Patentansprüche

1. Sensorsignaldetektionsschaltung (10) zum Erfassen einer Änderung in einem Gleichspannungssensorsignal (S) mit einer Niederfrequenzzustandsänderungskomponente (S1) und einer Hochfrequenzrauschkomponente (S2), die eine Gleichspannungspegeländerungskomponente (S3) überlagern, wobei die Gleichspannungspegeländerungskomponente (S3) durch eine Änderung einer zu erfassenden physikalischen Größe verursacht wird, umfassend:
einen Vergleichsbereich (24) zum Abtasten eines Referenzsignals (R) und des Gleichspannungssensorsignal (S), um jeweils ein erstes Abtastsignal und ein zweites Abtastsignal zu erhalten, und zum Vergleichen des ersten Abtastsignals mit dem zweiten Abtastsignal zur Ausgabe eines Vergleichssignals;
einen Tiefpassfilter (21) mit dem eingespeisten Gleichspannungssensorsignal (S), der geregelt ist, die Hochfrequenzrauschkomponente (S2) und die Gleichspannungspegeländerungskomponente (S3) von dem Gleichspannungssensorsignal (S) zu trennen, um den Durchgang der Niederfrequenzzustandsänderungskomponente (S1) zu ermöglichen;
einen Bereich (22) zur Erzeugung eines ersten Referenzsignals zur Umwandlung eines Amplitudenausgangssignals des Tiefpassfilters (21) in einem bestimmten Verhältnis (K), um ein erstes Referenzsignal (R1) zu erzeugen;
einen Bereich (25) zur Erzeugung eines zweiten Referenzsignals, um für den Fall, dass das Vergleichssignal ausgegeben wird, ein zweites Referenzsignal mit einem festgelegten Wert auf der Grundlage des ersten und des zweiten Abtastsignals zum Zeitpunkt der Vergleichssignalausgabe zu erzeugen; und
einen Auswahlbereich (23), um als Referenzsignal (R) das erste Referenzsignal oder das zweite Referenzsignal auszuwählen und dieses in den Vergleichsbereich einzuspeisen.

2. Sensorsignaldetektionsschaltung nach Anspruch 1, die so geregelt ist, dass für den Fall, dass das zweite Referenzsignal neu erzeugt wird während das erste Referenzsignal als das Referenzsignal ausgewählt wird, der Auswahlbereich das zweite Referenzsignal
anstelle des ersten Referenzsignals neu auswählt, und dass für den Fall, dass das Vergleichssignal als Folge eines Vergleichs zwischen dem zweiten Referenzsignal und dem Gleichspannungssensorsignal in dem Vergleichsbereich neu ausgegeben wird, der Auswahlbereich das erste Referenzsignal als das Referenzsignal neu ausgewählt.

3. Sensorsignaldetektionsschaltung nach Anspruch 1, die so geregelt ist, dass das zweite Referenzsignal einen festgelegten Wert aufweist, der durch Multiplizieren des ersten Abtastsignals zum Zeitpunkt der Vergleichssignalausgabe mit einem bestimmten Koeffizienten und/oder durch Addieren eines bestimmten Koeffizienten und des Abtastsignals zum Zeitpunkt der Vergleichssignalausgabe erzielt wird.

4. Berührungsaktiver Sensor umfassend:
einen Fühler (1) mit einem Kontakt zum Berühren eines zu messenden Objektes;
einen Anregungsbereich (6b), um den Fühler in Schwingung zu versetzen; und
eine Sensorsignaldetektionsschaltung (10) nach Anspruch 1.

## Revendications

1. Circuit de détection de signal de capteur (10) pour détecter un changement d'un signal de capteur CC (S) comprenant une composante de variation d'état de basse fréquence (S₁) et une composante de bruit de haute fréquence (S₂) superposées toutes les deux sur une composante de variation de niveau CC (S₃), la composante de variation de niveau CC étant entraînée par un changement d'une quantité physique destinée à être détectée, comprenant :
une partie de comparaison (24) pour échantillonner un signal de référence (R) et ledit signal de capteur CC (5) pour obtenir un premier signal d'échantillonnage et un second signal d'échantillonnage, respectivement, et pour comparer le premier signal d'échantillonnage et le second signal d'échantillonnage pour sortir un signal de comparaison ;
un filtre passe-bas (21) dans lequel est entré ledit signal de capteur CC (S) et qui tente de couper ladite composante de bruit de haute fréquence (S₂) et ladite composante de variation de niveau CC (S₃) à partir dudit signal de capteur CC (S) pour permettre le passage de ladite composante de variation d'état de basse fréquence (S₁) ;
une partie de génération de premier signal de référence (22) pour convertir une amplitude d'un signal de sortie du filtre passe-bas (21) à un rapport fixe (K) pour générer un premier signal de référence (R₁) ;
une partie de génération de second signal de référence (25) pour générer, au cas où ledit signal de comparaison est sorti, un second signal de référence possédant une valeur fixe fondée sur ledit premier ou ledit second signaux d'échantillonnage à un instant de sortie du signal de comparaison ; et
une partie de sélection (23) pour sélectionner, en tant que signal de référence (R), ledit premier signal de référence ou ledit second signal de référence et pour l'entrer dans ladite partie de comparaison.

2. Circuit de détection de signal de capteur selon la revendication 1, agencé de sorte que, au cas où ledit second signal de référence est nouvellement généré alors que ledit premier signal de référence est sélectionné en tant que signal de référence, ladite partie de sélection sélectionne nouvellement ledit second signal de référence à la place dudit premier signal de référence ; et, au cas où ledit signal de comparaison est nouvellement sorti en conséquence d'une comparaison entre ledit second signal de référence et ledit signal de capteur CC dans ladite partie de comparaison, ladite partie de sélection sélectionne nouvellement ledit premier signal de référence en tant que signal de référence.

3. Circuit de détection de signal de capteur selon la revendication 1, agencé de sorte que ledit second signal de référence soit une valeur fixe obtenue en multipliant ledit premier signal d'échantillonnage à l'instant de sortie dudit signal de comparaison par un certain coefficient, et/ou en ajoutant un certain coefficient audit premier signal d'échantillonnage à un instant de sortie dudit signal de comparaison.

4. Capteur tactile, comprenant :
un stylet (1) possédant un contact pour entrer en contact avec un objet destiné à être mesuré ;
une partie d'excitation (6b) pour appliquer une vibration sur le stylet ; et
un circuit de détection de signal de capteur (10) selon la revendication 1.
